(19) Europäisches Patentamt

European Patent Office

Office européen des brevets

(11) EP 0 938 746 B1

(12) **EUROPÄISCHE PATENTSCHRIFT**

(45) Veröffentlichungstag und Bekanntmachung des Hinweises auf die Patenterteilung:
**28.08.2002 Patentblatt 2002/35**

(21) Anmeldenummer: **97910209.2**

(22) Anmeldetag: **18.09.1997**

(51) Int Cl.$^7$: **H01L 21/306**, H01S 5/22

(86) Internationale Anmeldenummer:
**PCT/DE97/02121**

(87) Internationale Veröffentlichungsnummer:
**WO 98/014988 (09.04.1998 Gazette 1998/14)**

(54) **VERFAHREN ZUR NASS-CHEMISCHEN ÄTZUNG BZW. OBERFLÄCHENREINIGUNG VON ARSENHALTIGEN MISCHKRISTALLVERBINDUNGEN**

PROCESS FOR WET CHEMICAL ETCHING OR SURFACE CLEANING OF MIXED CRYSTAL COMPOUNDS CONTAINING ARSENIC

PROCEDE DE DECAPAGE OU DE NETTOYAGE DE SURFACE CHIMIQUE PAR VOIE HUMIDE DE COMPOSES A CRISTAUX MIXTES ARSENICAUX

(84) Benannte Vertragsstaaten:
**DE FR GB IT**

(30) Priorität: **30.09.1996 DE 19640422**

(43) Veröffentlichungstag der Anmeldung:
**01.09.1999 Patentblatt 1999/35**

(73) Patentinhaber: **Infineon Technologies AG**
**81669 München (DE)**

(72) Erfinder: **KLIMARS, Stefan**
**D-38124 Braunschweig (DE)**

(74) Vertreter: **Gross, Felix, Dr. et al**
**Patentanwälte**
**Maikowski & Ninnemann**
**Postfach 15 09 20**
**10671 Berlin (DE)**

(56) Entgegenhaltungen:
**US-A- 4 316 765          US-A- 4 830 986**

- **FERRANTE ET AL: "A slow selective etch for GaInAsP on InP" JOURNAL OF THE ELECTROCHEMICAL SOCIETY., Bd. 130, Nr. 5, Mai 1983, MANCHESTER, NEW HAMPSHIRE US, Seiten 1222-1224, XP002052137**
- **HOBSON W S ET AL: "INGAAS/ALGAAS RIDGE WAVEGUIDE LASERS UTILIZING AN INGAP ETCH-STOP LAYER" SEMICONDUCTOR SCIENCE AND TECHNOLOGY, Bd. 7, Nr. 11, 1.November 1992, Seiten 1425-1427, XP000336276**
- **HUO D T C ET AL: "CHEMICAL CLEANING OF GRATINGS IN DISTRIBUTED FEEDBACK INP LASERS" JOURNAL OF THE ELECTROCHEMICAL SOCIETY, Bd. 137, Nr. 11, 1.November 1990, Seiten 3639-3642, XP000161442**
- **KENJI SATO ET AL: "SELF-ALIGNED RIDGE-WAVEGUIDE DFB LASERS EMITTING AT 1.55 UM: RIDGE-WIDTH DEPENDENCE" JAPANESE JOURNAL OF APPLIED PHYSICS, Bd. 29, Nr. 10, 1.Oktober 1990, Seiten 1946-1950, XP000223985**

**Beschreibung**

Die Erfindung bezieht sich auf ein Verfahren zur nass-chemischen Ätzung bzw. Oberflächenreinigung von arsenhaltigen Mischkristallverbindungen bei III-V-Halbleitersystemen, welche insbesondere auf InP und/oder GaAs basieren. Die Erfindung bezieht sich ferner auf ein Verfahren zur Herstellung eines Stegwellenleiters in III-V-Verbindungshalbleiter-Schichtstrukturen, insbesondere zur Herstellung einer sogenannten Metal-Clad-Ridge-Waveguide -(MCRW-) Laservorrichtung auf InGaAsP/InP-Basis, sowie die Verwendung einer Ätz- bzw. Reinigungslösung mit den Bestandteilen Schwefelsäure und einem Oxidationsmittel.

Herkömmliche nass-chemische Ätzverfahren an arsenhaltigen Schichten der III-V-Halbleitersysteme auf der Basis von InP und GaAs beruhen meist auf Lösungen mit den Bestandteilen Schwefelsäure konzentriert (d.h. etwa 96 %-ige wässerige Lösung), Wasserstoffperoxid 30 % und Wasser. Solche Verfahren sind beispielsweise aus J. Electrochem. Soc.: Solid-State Science, Vol. 118, No. 5, Mai 1971, pp 768 - 771 bekannt geworden. Bei einem hohen Schwefelsäuregehalt in der Lösung, beispielsweise den Volumen-Mischungsverhältnissen 5:1:1 oder 3:1:1 (jeweils Schwefelsäure konzentriert:Wasserstoffperoxid:Wasser) bilden diese Komponenten hochviskose Mischungen, die polierend ätzen, und dabei außerdem mit steigendem Arsengehalt der zu ätzenden Schicht zunehmende Ätzraten aufweisen. Bei jedem Ansatz einer derartigen Ätzlösung tritt aufgrund der Volumenverhältnisse eine erhebliche Erwärmung auf, was sich im Hinblick auf Kontrollierbarkeit und Reproduzierbarkeit der geätzten Strukturen nachteilig auswirken kann. Im Allgemeinen muss daher die bei Schwefelsäure/Wasser- bzw. Schwefelsäure/Wasserstoffperoxid-Ätzlösungen auftretende Hydratationswärme bei der Anwendung bei III-V-Halbleiterschichten des InP- oder GaAs-Systems abgeführt werden. Die Ätzlösung wird zumeist bei Raumtemperatur eingesetzt, um die Ätzwirkung kontrollierbar zu halten. Die bei der zum Teil starken Erwärmung der Ätzlösung eintretende thermische Zersetzung des Wasserstoffperoxid-Anteils begrenzt vor allem die Reproduzierbarkeit der Ätzwirkung. Das Ätzergebnis wird abhängig vom Mischungsverfahren der Bestandteile der Ätzlösung und von der Standzeit der Ätzlösung. Da des Weiteren die vorbekannten Zusammensetzungen in der Regel auch als Polierätzlösungen für InP benutzt werden, ist die Ätzselektivität nicht so groß wie gewünscht. Der mit dem Lösungsmittel Wasser volumengleiche Wasserstoffperoxidanteil bedingt relativ hohe Ätzraten. Derartige Ätzlösungen kommen daher für Anwendungen mit hohen Anforderungen an die Strukturgenauigkeiten nicht in Betracht.

Gleichzeitig mit der Ätzwirkung liegt bei den vorbekannten Ätzlösungen mit hohem Schwefelsäuregehalt im Beisein eines Oxidationsmittels wie Wasserstoffperoxid eine universelle Reinigungswirkung vor, die - wie in der Si-Wafer-Technologie praktiziert - durch hohe Temperaturen unterstützt wird (sogenannte RCA-Reinigung). Der Effekt der Eigenerwärmung bei einer Vermischung der Bestandteile der Ätzlösung ist daher für diese Anwendungen besonders von Nutzen.

Ein weiterer Einsatzbereich bekannter Ätzlösungen betrifft diejenigen Fälle, bei denen die Reaktionsrate im Vergleich zu den vorstehend genannten 5/3:1:1-Ätzlösungen reduziert werden muss und die Anforderungen im Hinblick auf die Strukturgenauigkeiten nicht sonderlich hoch sind. Bei solchen Anwendungen kommen Volumenzusammensetzungen von 1:8:20 oder 1:8:80 oder 1:1:50 (jeweils konzentrierte Schwefelsäure:30 %-iges Wasserstoffperoxid:Wasser) für den selektiven, kontrollierten Ätzabtrag in III-V-Halbleitersystemen zum Einsatz. Häufig ist das Ziel hierbei die Strukturierung von Kontaktschichten. Wegen des im Allgemeinen niedrigen Schwefelsäuregehalts entsteht bei diesen Lösungen während der Mischung keine merkliche Hydratationswärme. Aus demselben Grund gehen jedoch einige wichtige chemisch-physikalische Eigenschaften verloren. Hierzu zählt die Reinigungswirkung gegenüber Partikeln, anorganischen und organischen Verbindungen, sowie die relativ hohe Viskosität hochkonzentrierter Schwefelsäure.

Weitere Einzelheiten zu den vorbekannten Verfahren bei der nass-chemischen Ätzung bzw. Oberflächenreinigung von arsenhaltigen Mischkristallverbindungen sind beispielsweise aus D. T. C. Huo, J. D. Wynn, S. G. Napholtz, D. P. Wilt, Preferential Etching of InP Through Photoresist Masks, J. Electrochem. Soc.: SOLID-STATE SCIENCE AND TECHNOLOGY, September 1988, Vol. 135, No. 9, Seiten 2334 bis 2338, sowie L. A. Coldren, K. Furuya, B. I. Miller, On the Formation of Planar-Etched Facets in GaInAsP/InP Double Heterostructures, J. Electrochem. Soc.: SOLID-STATE SCIENCE AND TECHNOLOGY, September 1983, Vol. 130, No. 9, Seiten 1918 bis 1926 bekannt geworden. Ein Verfahren zur Herstellung eines Stegwellenleiters ist beispielsweise aus der US-A-5059552 oder US-A-4830986 bekannt.

Aus der US-A-4316765 sind Ätzlösungen zur Bestimmung von Defekten in Halbleitermaterialien auf der Basis arsenhaltiger Indiumphosphid-Verbindungen nach dem Oberbegriff des Anspruchs 1 bekannt. Die Ätzlösung setzt sich beispielsweise zusammen aus $H_2O_2$, $H_2SO_4$ und $H_2O$, das Mischungsverhältnis beträgt 0,03 : 3 : 1,97. Man geht von einer verdünnten Schwefelsäure aus, zu der eine 3 %-ige Lösung von $H_2O_2$ dazugegeben wird.

Der vorliegenden Erfindung liegt die Aufgabe zugrunde, ein Verfahren zur nass-chemischen Ätzung bzw. Oberflächenreinigung arsenhaltiger Mischkristallverbindungen der III-V-Halbleitersysteme zur Verfügung zu stellen, welches unabhängig von Unzulänglichkeiten der Maskenhaftung der bei der Ätzung bzw. Reinigung zum Einsatz gelangenden Ätzmaske und unabhängig von sonstigen störenden mechanisch-physikalischen Einflüssen wie beispielsweise Kratzern und dergleichen eine kontrollierte, lateral gleichmäßige Ätzwirkung ermöglicht.

Diese Aufgabe wird durch das Verfahren gemäß Anspruch 1 gelöst. Eine bevorzugte Anwendung des erfindungsgemäßen Verfahrens ist in den Ansprüchen 7 bis 19 angegeben.

Erfindungsgemäß ist vorgesehen, dass zur Durchführung der nass-chemischen Ätzung bzw. Oberflächenreinigung eine Ätz- bzw. Reinigungslösung mit den Bestandteilen Schwefelsäure und einem Oxidationsmittel verwendet wird, wobei die Volumenkonzentration des Oxidationsmittels in der Ätz- bzw. Reinigungslösung kleiner als etwa 3 % beträgt. Hierbei ist insbesondere vorgesehen, dass die in der Ätz- bzw. Reinigungslösung verwendete Schwefelsäure in nichtkonzentrierter Form vorliegt, insbesondere in 75 %-iger Konzentration. Von besonderem Vorteil stellt das in der Ätz- bzw. Reinigungslösung verwendete Oxidationsmittel Wasserstoffperoxid dar.

Die Erfindung beruht auf der Erkenntnis, eine Ätz- und Reinigungslösung für arsenhaltige Mischkristallverbindungen der III-V-Halbleitersysteme basierend insbesondere auf InP und GaAs mit den Bestandteilen Schwefelsäure, Wasserstoffperoxid, Wasser zu verwenden, bei der anstelle einer konzentrierten Schwefelsäure eine mit Wasser verdünnte Schwefelsäure vorgesehen wird, wobei das Schwefelsäure-Wasser-Verhältnis voreingestellt ist, und darüber hinaus eine nur geringe Konzentration des Oxidationsmittels Wasserstoffperoxid von weniger als etwa drei Volumenprozent vorzusehen. Aufgrund der erfindungsgemäßen Zusammensetzung der Ätz- und Reinigungslösung werden zum Einen die im Hinblick auf die entstehende Hydratationswärme und damit zusammenhängend eintretenden thermischen Zersetzungen insbesondere des Wasserstoffperoxidanteils einhergehenden Nachteile vermieden, und zum Anderen bleiben die günstigen chemischen und physikalischen Eigenschaften einer Ätzlösung mit hohem Schwefelsäuregehalt erhalten. Erfindungsgemäß wird die Ätzaktivität der Ätzlösung an arsenhaltigen Schichten allein durch den variablen Wasserstoffperoxidanteil bestimmt.

Hierdurch bedingt ergeben sich für nass-chemische Ätz- bzw. Reinigungslösungen im angegebenen Anwendungsbereich völlig neuartige vorteilhafte Eigenschaften:

- Die Maskenunterätzung wird nicht mehr durch die Maskenhaftung als schwer zu kontrollierendem Parameter bestimmt.
- Unter der Voraussetzung chemischer Homogenität des Schichtmaterials lässt sich eine kontrollierte, lateral extrem gleichmäßige Ätzwirkung erzielen, die nicht einmal durch mechanisch-physikalische Einflüsse wie etwa Kratzer oder dergleichen zu stören ist (die vertikale Gleichmäßigkeit der Ätzung ist durch die vorhandene Selektivität gegenüber chemisch heterogenen Schichtsystemen vieler III-V-Halbleiterbauelemente ohnehin gegeben).

- Eine Unterätzung als meist unvermeidbare Begleiterscheinung herkömmlicher nass-chemischer Ätzverfahren wird nach der Erfindung zu einem gezielt nutzbaren Effekt. So können beispielsweise komplizierte Verfahrenstechniken für Abhebeprozesse überflüssig gemacht werden.

Die genannten vorteilhaften Merkmale der Ätzwirkung hängen unmittelbar mit einigen der folgenden Grundeigenschaften der erfindungsgemäßen Ätz- bzw. Reinigungslösung zusammen:

- Es liegt eine hohe Selektivität zwischen arsenhaltigen und nicht arsenhaltigen Schichten vor, das Ätzratenverhältnis beträgt demzufolge typischerweise mehr als etwa 500:1.
- Der geringe Wasserstoffperoxid-Volumenanteil in der Schwefelsäure-Mischung bedingt eine sehr hohe Selektivität zwischen herkömmlichen Positiv-Lacksystemen und ätzbarem Halbleitermaterial, wobei die Zersetzung der Photolacke aufgrund des Ätzangriffs so gering ist, dass sie nur bei Ätzzeiten im Bereich von Stunden überhaupt nachweisbar wird.
- Der Wirkungsmechanismus an arsenhaltigen Schichten wird über den Wasserstoffperoxidgehalt der Ätz- bzw. Reinigungslösung eindeutig bestimmt. Die Reaktionsrate und damit zusammenhängende Eigenschaften der Ätzlösung wie beispielsweise Richtungsunabhängigkeit der Ätzrate (isotropes Ätzverhalten) können somit gezielt auf spezielle Anwendungen abgestimmt werden.
- Die Ätz- bzw. Reinigungslösung kann wegen des verhältnismäßig hohen Schwefelsäuregehaltes als spezifische Reinigungslösung benutzt werden, in dem der Wasserstoffperoxidgehalt
- abhängig vom zu ätzenden arsenhaltigen Schichtmaterial - auf sehr niedrige Werte gesenkt wird (beispielsweise Volumenkonzentrationen im 0,1%-Bereich). Die Reaktionsraten sinken dabei auf nicht mehr feststellbare Werte. Im Übrigen kann die gleiche Ätz- bzw. Reinigungslösung durch eine nachträgliche Wasserstoffperoxidzugabe anschließend wieder zum Ätzen benutzt werden.
- Da der Lösungsansatz ein voreingestelltes Schwefelsäure/Wasser-Verhältnis verwendet, gibt es bei Zusatz des geringen Wasserstoffperoxidanteils keine merkliche Erwärmung.

Aus der fehlenden Eigenerwärmung leiten sich unmittelbar weitere wichtige Eigenschaften der erfindungsgemäßen Ätz- bzw. Reinigungslösung ab:

- Die Lösung ist sofort nach Zugabe des Oxidationsmittels wie z.B. Wasserstoffperoxids und Durchmischung verwendbar.

- Es findet keine nachweisbare Zersetzung des durch Temperaturerhöhung besonders zersetzungsgefährdeten Wasserstoffperoxidanteils statt, da diese Substanz unter gewöhnlichen Lagerbedingungen bei Raumtemperatur stabil bleibt. Eine von selbst erzeugte störende Blasenbildung im Reaktionsmedium wird dadurch verhindert.
- Es ist durch gezielte Wasserstoffperoxid-Zugabe eine definierte Wasserstoffperoxid-Konzentrationseinstellung möglich. Eine Abhängigkeit vom Herstellungs- bzw. Mischungsverfahren (beispielsweise durch Größe des Mengenansatzes oder Kühlungsbedingungen während der Mischung der Komponenten) kann nicht bestehen. Weiterhin sind Konzentrationsfehler durch Volumenausdehnungs- und Zersetzungseffekte ausgeschlossen.
- Die erfindungsgemäße Ätz- bzw. Reinigungslösung ermöglicht eine einfache Handhabbarkeit, da die Ätzlösung lediglich zweikomponentig und gefahrlos, d.h. ohne Erwärmung angesetzt werden kann.
- Lange Standzeiten der Lösung in der Größenordnung bis zu 48 Stunden sind durch den Einsatz stabiler bzw. stabil gehaltener Lösungskomponenten möglich. Frische Lösungsansätze oder definierte Standzeiten sind somit keine Voraussetzung für die Reproduzierbarkeit des Ätzergebnisses.

Die erfindungsgemäße Ätz- bzw. Reinigungslösung zeichnet sich aufgrund der vorgenannten Eigenschaften durch ein Höchstmaß an Reproduzierbarkeit und Gleichmäßigkeit in der Ätzwirkung aus. Das erfindungsgemäße nass-chemische Verfahren ist Trockenätzverfahren in solchen Anwendungsfällen überlegen, bei denen es auf eine sehr hohe laterale Gleichmäßigkeit und definierte Maskenstrukturtreue ankommt. In vorteilhafter Weise tragen hierzu neben den bereits genannten Eigenschaften auch die folgenden günstigen Merkmale nass-chemischer Verfahren bei:

- Die Flanken der bei der Ätzung/Reinigung zum Einsatz gelangenden Photolackmasken sind im Wesentlichen erosionsfrei, so dass das laterale Ätzmaß unabhängig von Unterschieden in den Photolacksteilheiten eingestellt werden kann.
- Es findet eine Verrundung der Kantenformen bei der Maskenstruktur statt, was von Verteil insbesondere bei Ätz- bzw. Reinigungslösungen mit isotropem Ätzverhalten ausgenutzt werden kann.

Die Kombination dieser Merkmale mit den vorstehend genannten vorteilhaften Eigenschaften der erfindungsgemäßen Ätz- bzw. Reinigungslösung ergibt ein außergewöhnliches Ätzverhalten mit folgenden Charakteristika:

- Es ergibt sich eine Ausgleichswirkung bzw. Unempfindlichkeit gegenüber lokalen Störungen der Maskengeometrie der verwendeten Photolackmaske.

- Es besteht eine Ausgleichswirkung bzw. Unempfindlichkeit sogar gegenüber lokalen Halbleiter-Strukturstörungen mechanisch-physikalischer Natur, beispielsweise aufgrund von Kratzern, Versetzungsnetzwerken und dergleichen.
- Das Ergebnis der Ätzung nach Verwendung der erfindungsgemäßen Ätz- bzw. Reinigungslösung zeigt eine außerordentliche Unabhängigkeit gegenüber Haftungsunterschieden des Maskenmaterials auf der Halbleiteroberfläche.

Dank der extremen Gleichmäßigkeit im Unterätzungsverhalten eignet sich das erfindungsgemäße Ätz- bzw. Reinigungslösungssystem besonders für alle selbstjustierend hergestellte Bauelemente, deren Isolations- bzw. Passivierungsschicht vermittels einem Abhebeschritt (sogenannter "Lift-Off-Prozess") strukturiert wird. So kann etwa das Herstellungsverfahren eines MCRW-Halbleiter-Lasers in idealer Weise von den eingangs genannten vorteilhaften Nass-Ätz-Eigenschaften der erfindungsgemäßen Ätz- und Reinigungslösung profitieren. Eine erhebliche Verfahrensvereinfachung, zusammen mit einem Gewinn an Prozess-Sicherheit ermöglicht beachtliche Fortschritte im Hinblick auf die Ausbeute und die Verkürzung der Durchlaufzeit bei der Herstellung derartiger Halbleiterlaservorrichtungen.

Demgemäß eignet sich die erfindungsgemäße Ätz- bzw. Reinigungslösung zur Herstellung eines Stegwellenleiters in III-V-Verbindungshalbleiter-Schichtstrukturen, insbesondere mit den Schritten: Fertigen einer auf einem Halbleiter-Substrat insbesondere durch epitaktisches Aufwachsen ausgebildeten Grundstruktur mit einer ersten Mantelschicht, einer auf der ersten Mantelschicht abgeschiedenen aktiven Zone bestehend aus einheitlichem Material oder aus einer Wechselfolge von Quantentöpfen und Barrieren, einer auf der aktiven Zone abgeschiedenen zweiten Mantelschicht und einer auf der zweiten Mantelschicht abgeschiedenen Kontaktschicht; ganzflächiges Abscheiden und Strukturieren einer Grabenmaske zur Festlegung eines Grabenbereichs, der eine vielfache Breite eines nachfolgend innerhalb des Grabenbereichs aus der zweiten Mantelschicht und der Kontaktschicht zu erzeugenden Steges besitzt; Ausbilden einer im Wesentlichen streifenförmigen Stegmaske innerhalb des Grabenbereichs; selektives Ätzen der Kontaktschicht und der zweiten Mantelschicht unter Verwendung der Grabenmaske und der Stegmaske als Abdeckmasken zur Ausbildung des Steges des Stegwellenleiters bei gleichzeitiger Ausbildung eines Grabens innerhalb des Grabenbereiches; im Wesentlichen kantenkonformes Abscheiden einer Passivierungsschicht aus elektrisch isolierendem Material; Abheben des auf der Stegmaske abgeschiedenen Materials der Passivierungsschicht durch Entfernen des unterliegenden Maskenmaterials der Stegmaske; und Abscheiden einer Metallisierungsschicht für den elektrischen Anschluss des Steges.

Weitere vorteilhafte Ausgestaltungen des erfindungsgemäßen Verfahrens bzw. der erfindungsgemäßen Verwendung ergeben sich aus den weiteren Ansprüchen.

Weitere Merkmale, Vorteile und Zweckmäßigkeiten der Erfindung ergeben sich aus der nachfolgenden Beschreibung von Ausführungsbeispielen anhand der Zeichnung. Es zeigen:

Figuren 1 bis 8 in schematischen Schnittansichten die Reihenfolge der Prozess-Schritte eines Verfahrens zur Herstellung eines Stegwellenleiters in III-V-Verbindungshalbleiter-Schichtstrukturen gemäß einem Ausführungsbeispiel der Erfindung;

Figur 9 eine schematische Draufsicht einer Photolackstruktur, deren ursprüngliche 90°-Kanten infolge der Unterätzung nach einem isotropen nasschemischen Ätzschritt bei der Strukturierung einer InGaAsP-Kontaktschicht verrundet werden;

Figur 10 eine schematische Draufsicht zur Erläuterung des Ausgleiches bzw. Glättung massiver Randstörungen einer Photolackmaske am Beispiel einer kreisförmigen Kontaktbereichsstrukturierung in einem InGaAsP-Schichtmaterial; und

Figur 11 eine schematische Draufsicht einer Stegwellenleiter-Struktur zur Erläuterung der Unabhängigkeit des erfindungsgemäßen Ätzverfahrens gegenüber lokalen Halbleiter-Strukturstörungen mechanisch-physikalischer Natur.

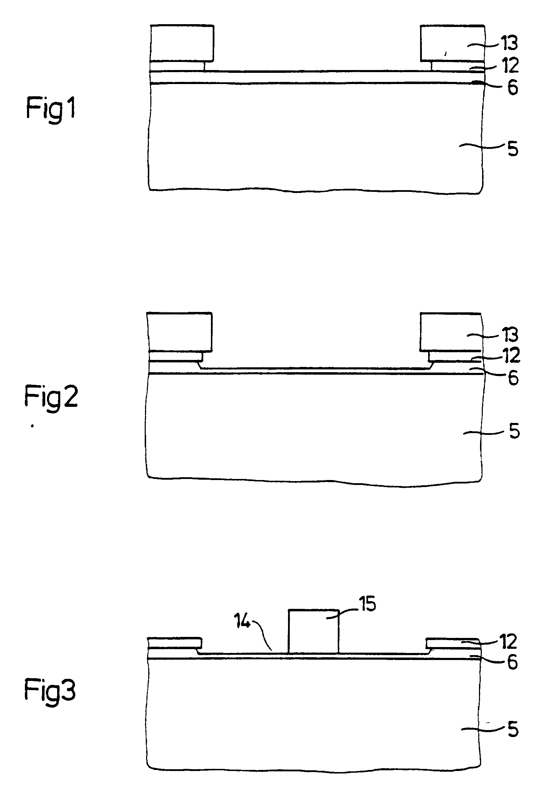

Anhand der Figuren 1 bis 8 wird zunächst eine bevorzugte Anwendung des erfindungsgemäßen Ätz- bzw. Reinigungsverfahrens bei der Herstellung einer Metal-Clad-Ridge-Waveguide -(MCRW-) Laservorrichtung gemäß einem ersten Ausführungsbeispiel der Erfindung beschrieben.

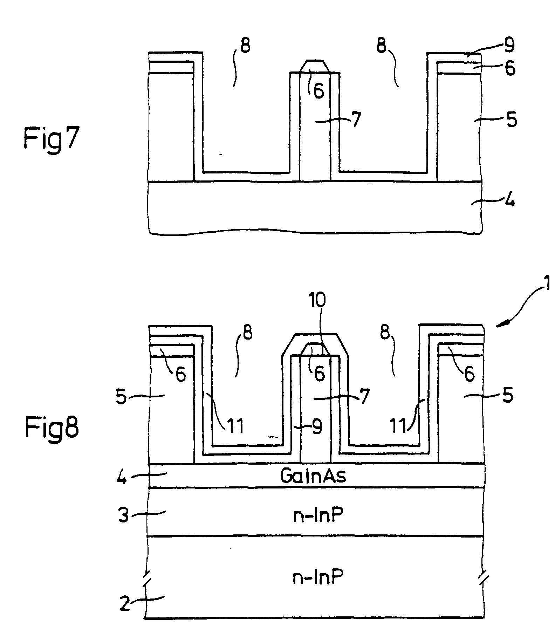

Bevor die einzelnen Verfahrensschritte zur Fertigung einer erfindungsgemäßen Halbleiterlaservorrichtung gemäß Ausführungsbeispiel anhand der Figuren 1 bis 7 näher erläutert wird, wird zunächst anhand der schematischen Darstellung nach Figur 8 die fertiggestellte Halbleiterlaservorrichtung erläutert. Das Ausführungsbeispiel nach Figur 8 umfasst eine Metal-Clad-Ridge-Waveguide-(MCRW-) Laservorrichtung 1 mit einer auf einem Halbleiter-Substrat 2 aus n-dotiertem InP insbesondere durch epitaktisches Aufwachsen ausgebildeten Grundstruktur mit einer gleichfalls aus n-dotiertem InP bestehenden ersten Mantelschicht 3, einer auf der ersten Mantelschicht 3 abgeschiedenen aktiven Zone 4, einer auf der aktiven Zone 4 abgeschiedenen zweiten Mantelschicht 5 aus p-dotiertem InP, und einer auf der zweiten Mantelschicht 5 abgeschiedenen Kontaktschicht 6 aus p$^+$-dotiertem GaInAs. Die für die Rekombination und Lichterzeugung dienende aktive Zone 4 kann entweder aus einheitlichem Material oder aus einer Wechselfolge von Quantentöpfen und Barrieren bestehen; im dargestellten Ausführungsbeispiel ist die aktive Zone 4 durch eine GaInAs-Doppel-Heterostruktur gebildet. Die aktive Zone 4 ist in an sich bekannter Weise von den ersten und zweiten Mantelschichten 3 und 5 umgeben, welche einen größeren Bandabstand als das Material der aktiven Zone besitzen, und zusammen mit einem streifenförmigen Steg 7 einen Wellenleiter bilden und die notwendige Ladungsträgereingrenzung bewirken. Der Steg 7 des Stegwellenleiters ist hierbei innerhalb eines in der zweiten Mantelschicht 5 und der Kontaktschicht 6 gefertigten Grabens 8 gebildet, wobei die Breite des Grabens 8 etwa das zwanzigfache der Breite des Steges 7 besitzt. Der Steg 7 weist beispielsweise eine Breite von etwa 2 bis 3 μm und eine Höhe von etwa 1,5 bis 3 μm auf; die schematische Darstellung nach Figur 8 ist somit nicht streng maßstabsgetreu. Die Bezugsziffer 9 bezeichnet eine Passivierungsschicht aus vorzugsweise Al$_2$O$_3$, welche mit Ausnahme der auf der Oberseite 10 des Steges 7 sämtliche Bestandteile der Laservorrichtung 1 kantenkonform überdeckt. Darauf abgeschieden befindet sich eine Metallisierungsschicht 11 für den elektrischen Anschluss des Steges 7 an Kontaktanschlüsse und äussere Kontaktzuführungen, vermittels derer der zum Betrieb des Lasers 1 notwendige Laserstrom zugeführt wird, welche jedoch aus Gründen der Übersichtlichkeit in den Figuren nicht näher dargestellt sind.

Nachfolgend werden anhand der Figuren 1 bis 7 in dieser Reihenfolge die aufeinanderfolgenden Prozess-Schritte zur Fertigung der erfindungsgemäßen Laservorrichtung näher erläutert, wobei in diesen Figuren aus Gründen der besseren Übersichtlichkeit das Halbleiter-Substrat 2 und die erste Mantelschicht 3 nicht mehr dargestellt sind.

Auf die anhand Figur 8 näher erläuterte Grundstruktur mit den Schichten 3 bis 6 wird zunächst ganzflächig eine Hilfsmaskenschicht 12 aus InP vorzugsweise epitaktisch abgeschieden, was zweckmäßigerweise in einem Arbeitsgang während des Epitaxiewachstums der gesamten Grundstruktur erfolgt. Die Schicht 12 besteht aus gegenüber der Kontaktschicht 6 selektiv ätzbarem Material und besitzt eine Stärke von etwa 0,2 μm. Die Hilfsmaskenschicht 12 begünstigt bzw. vereinfacht die nachfolgende Fertigung des Steges 7 im Sinne einer Verringerung der Anzahl von Prozess-Schritten, und unterstützt im Übrigen die Definition einer sauberen Abhebekante beim abschließenden Abhebeschritt, kann jedoch auch weggelassen werden, ohne vom erfindungsgemäßen Prinzip abzuweichen. Auf die ganzflächig abgeschiedene Hilfsmaskenschicht 12 wird Photolackmaterial aufgetragen, auf herkömmliche Weise photolithographisch belichtet und zur Ausbildung einer Grabenmaske 13 strukturiert, die für die folgenden Ätzschritte den Oberflächenbereich definiert, in welchem der in der umgebenden Grundstruktur versenkte Stegwellenleiter entstehen soll. In einer nachfolgenden nass-chemischen Ätzung wird zunächst die Hilfsmaskenschicht 12 an den von der Grabenmaske 13 nicht abgedeckten Stellen entfernt. Die Strukturierung der Hilfsmaske 12 ist in Figur 1 schematisch dargestellt.

Daran anschließend kann gemäß Figur 2 unter Verwendung der Grabenmaske 12, 13 die Kontaktschicht 6 zur Dickenkorrektur nass-chemisch wenigstens angeätzt werden, wobei dieser Ätzschritt im Prinzip auch weggelassen werden kann.

Nachfolgend wird die bei den weiteren Schritten nicht mehr benötigte Fotolackmaske 13 entfernt, wobei die strukturierte Schicht 12 im Folgenden die Funktion der Grabenmaske übernimmt.

Daran anschließend wird vermittels herkömmlicher Phototechnik innerhalb des Grabenbereichs 14, vorzugsweise mittig eine streifenförmige Stegmaske 15 aus Photolack ausgebildet, welche die Lage des zu ätzenden Wellenleitersteges definiert (Figur 3).

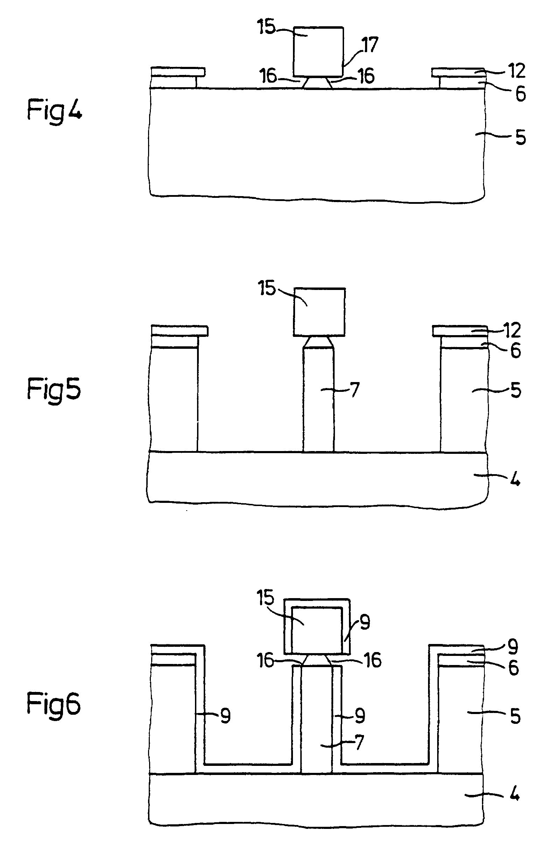

Im nachfolgenden Prozess-Schritt wird gemäß Figur 4 unter Verwendung der Stegmaske 15 und der Hilfsmaskenschicht 12 als Abdeckmasken die Kontaktschicht 6 selektiv durch einen nass-chemischen Prozess mit exakt definierter Stegmaskenunterätzung dahingehend geätzt, dass das Ausmaß der Unterätzung an den mit der Bezugsziffer 16 bezeichneten Stellen weder von der Haftung der Photolackmaske 15 noch von lokalen Störungen der Kontaktschicht 6, noch von mikroskopischen Ungleichmäßigkeiten der Photolackflanken 17 beeinflusst wird. Dieser Ätzprozess definiert die oberen seitlichen Abmessungen sowie die Homogenität der Breite des entstehenden Steges und bewirkt in Folge der Maskierungswirkung der Hilfsmaskenschicht 12 im Außenbereich des Grabens eine Einbettung des Steges durch das unveränderte Epitaxie-Schichtensystem angrenzend an die in der ersten Phototechnik definierten Grabenabschnitte seitlich des Steges.

Zur nass-chemischen Ätzung der Kontaktschicht 6 wird vorzugsweise eine Schwefelsäure-Wasserstoffperoxid-Wasser-Ätzlösung verwendet, wobei die Ätzung selektiv gegenüber dem Material der zweiten Mantelschicht 5 erfolgt, d.h. der Ätzvorgang kommt in vertikaler Richtung an der zu ätztenden Schicht 6 unmittelbar folgenden Grenzfläche der zweiten Mantelschicht 5 aufgrund der materialspezifischen Selektivität der Ätzlösung zum Stehen (Ätzstopwirkung der zweiten Mantelschicht 5 gegenüber der gewählten Ätzlösung). Gleichzeitig besteht ausreichende chemische Selektivität der gewählten Ätzlösung gegenüber der Grabenmaske 12, so dass das Material der Hilfsmaskenschicht 12 bei der Ätzung der Kontaktschicht 6 innerhalb der Nachweisgrenze nicht angegriffen wird. Vorteilhafterweise sind die Seitenwände der streifenförmigen Photolack-Stegmaske 15, und im Übrigen auch die Seitenwände der Grabenmaske 12 parallel zu den kristallographischen Richtungen [011] oder [0$\bar{1}$1] orientiert. Mit diesem Ätzschritt gelingt eine gleichmäßig laterale Unterätzung der Photolack-Stegmaske 15, wobei die Flankenwinkel der geätzten Kontaktschicht 6 an den mit der Bezugsziffer 15 angedeuteten Stellen eindeutig durch die kristallographisch bedingten Eigenschaften des Kontaktschichtmaterials vorgegeben bzw. bestimmt werden. Der Grad der Unterätzung der Kontaktschicht 6 an den Stellen 16 bestimmt gleichzeitig in eindeutiger Weise die Breite des nachfolgend vervollständigten Wellenleitersteges 7. Die erfindungsgemäß von Vorteil ausgenutzte Unterätzung der Kontaktschicht 6 kann dabei so gewählt werden, dass es beim nachfolgenden Abscheiden der Passivierungsschicht 9 nicht zu einer unerwünschten Verkleinerung der ohmschen Kontaktfläche auf der Oberseite 10 des Steges kommt. Im Zuge der mehr oder weniger ausgeprägten Flankenbildung an den Stellen 16 wird effektiv die Grenzfläche zwischen der später aufgebrachten Metallisierung 11 und der Kontaktschicht 6 an der Oberseite 10 vergrößert, so dass der Kontaktwiderstand letztlich sogar geringer eingestellt werden kann.

Daran anschließend erfolgt gemäß Figur 5 eine selektive nass-chemische Ätzung der zweiten Mantelschicht 5 zur Ausformung des Stegwellenleiters mit in weiten Grenzen veränderbarer Flankenform. Hierbei wird die reproduzierbar erzielbare Stegform außer durch die festgelegte Kristallrichtung und die vorgehende Kontaktschichtätzung insbesondere durch die Ätzlösung, die Ätzzeit und die Ätztemperatur, im Hinblick auf die Tiefe des Steges unter Umständen auch durch den konkreten Aufbau der Epitaxie-Schichtenfolge bestimmt. Aufgrund einer geeignet aufeinander abgestimmten Ätzlösung und Materialzusammensetzung wird bei diesem Prozess-Schritt gleichzeitig die restliche Hilfsmaskenschicht 12 im Außenbereich des Grabens entfernt. Wegen der chemischen Selektivität dieses Ätzprozesses übernimmt nach vollständiger Auflösung der Hilfsmaskenschicht 12 die noch verbleibende Kontaktschicht 6 die weitere Maskierungsfunktion. Zur nass-chemischen Ätzung der zweiten Mantelschicht 5 wird in bevorzugter Weise eine Phosphor-Salzsäure-Lösung verwendet, wobei aufgrund der chemischen Selektivität das Material der Kontaktschicht 6 und die unterhalb der zweiten Mantelschicht 5 angeordnete Schicht 4 von dieser Ätzlösung nicht angegriffen wird. Die Schicht 4 dient somit bei diesem Ätzschritt wiederum als Ätzstop. Bei der nass-chemischen Ätzung der zweiten Mantelschicht 5 findet keine Überätzung gegenüber der als Maske wirkenden Kontaktschicht 6 statt, so dass die im vorhergehenden Ätzschritt eingestellte Unterätzung der Kontaktschicht 6 an den Stellen 16 eindeutig die Stegbreite des Wellenleitersteges 7 bestimmt.

Daran anschließend wird gemäß Figur 6 eine Passivierungsschicht aus $Al_2O_3$ ganzflächig-und kan-

tenkonform auf die sich ergebende Gesamtstruktur vermittels einem ionenstrahlgestützten Sputter-Prozess aufgebracht, wobei an den mit der Bezugsziffer 16 bezeichneten Stellen technologisch sauber definierte Lükken in der Passivierungsschicht 9 verbleiben, durch die im nachfolgenden Abhebeschritt das im Abhebeprozess zum Einsatz gelangende Lösungsmittel ohne Weiteres eindringen kann.

Figur 7 zeigt den entsprechenden Zustand nach dem Abheben des auf der Photolackoberfläche gesputterten Al$_2$O$_3$-Materials durch Auflösen des Photolacks der Stegmaske 15 in einem geeigneten Lösungsmittel unter Ausnutzung der gezielten Unterätzung des Photolacks während der vorhergehenden Kontaktschichtätzung.

In einem abschließenden Metallisierungsschritt wird gemäß Figur 8 eine Metallisierungsschicht 11 für den elektrischen Anschluss des Steges 7 aufgebracht.

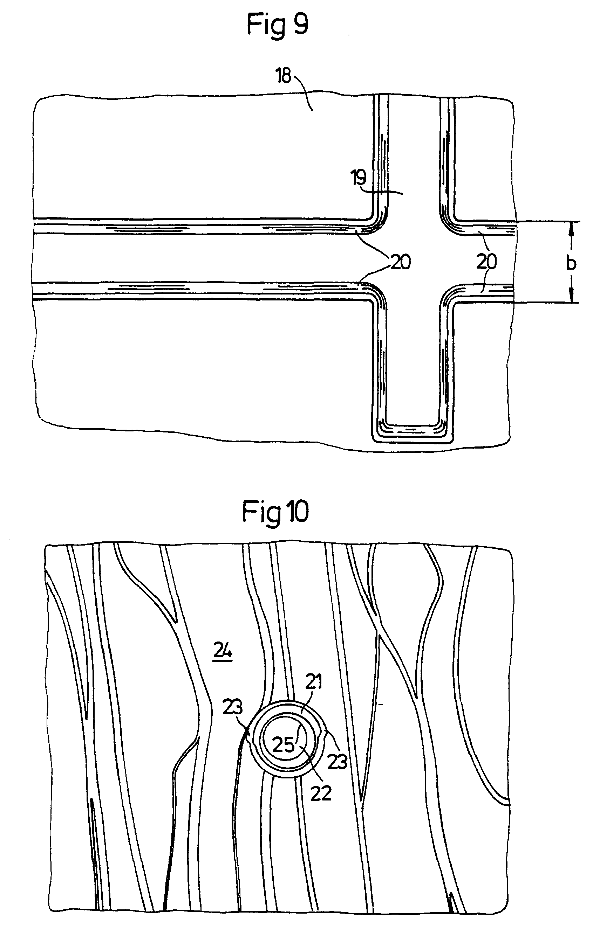

Die Figuren 9, 10 und 11 stellen nachgezeichnete Abbildungen von photographierten Mikroskopiebildern dar, die in Drauflicht von mit einer strukturierten Photolackmaske überdeckten Halbleiterstrukturen aufgenommen wurden.

Figur 9 zeigt in schematischer Draufsicht die Strukturierung einer InGaAsP-Kontaktschicht 18 vermittels der erfindungsgemäßen Ätz- und Reinigungslösung unter Verwendung einer Photolackstruktur 19 als Abdeckmaske bei der isotropen Nassätzung. Die Breite der ursprünglichen Photolackbedeckung vor Anwendung des nass-chemischen Ätzschrittes ist in Figur 9 schematisch anhand des Bezugszeichens b angedeutet. Nach Durchführung der isotropen Nassätzung mit Unterätzung vermittels einer 60:1 (75 %-ige Schwefelsäure:Wasserstoffperoxid) -Ätzlösung nach einer Gesamtätzzeit von 2 min zeigte sich eine Verrundung der ursprünglichen 90°-Kanten der Photolackstruktur 19 in Folge der Unterätzung bei dem nass-chemischen Ätzschritt. Die Verrundung des geätzten Kontaktschichtmaterials gegenüber der ursprünglichen Photolackkante ist schematisch an den Stellen 20 angedeutet.

Figur 10 zeigt die Ausgleichswirkung bzw. Unempfindlichkeit des erfindungsgemäßen Verfahrens bei Anwendung des bevorzugten Ätz- bzw. Reinigungslösungssystems gegenüber lokalen Störungen der Maskengeometrie am Beispiel einer kreisförmigen Kontaktbereichsstrukturierung 21 in einem InGaAsP-Schichtmaterial 22. Man erkennt in Figur 10 ohne Weiteres, dass trotz massiver Randstörungen 23 der Photolackmaske 24 der Boden der Kontaktbereichsstrukturierung 21 nach Durchführung der Ätzung im Wesentlichen streng kreisförmig (Kreislinie 25) ausgebildet ist, die Randstörungen 23 der Photolackmaske 24 somit vollständig ausgeglichen bzw. geglättet wurden. Es wurde eine Ätzlösung mit derselben Zusammensetzung wie bei dem Ausführungsbeispiel nach Figur 9 verwendet, die Gesamtätzzeit betrug 5,5 min.

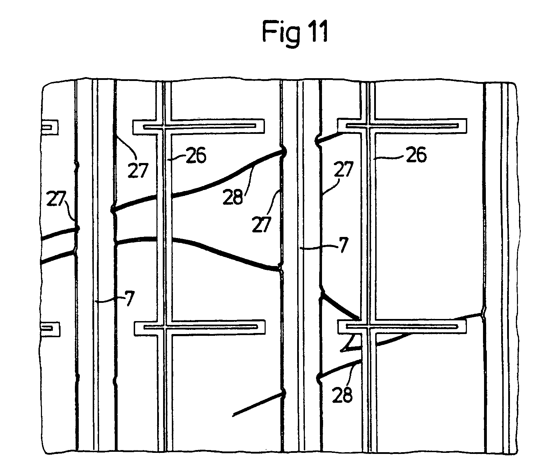

Die schematische Draufsicht nach Figur 11 zeigt schließlich die Unempfindlichkeit des erfindungsgemäßen nass-chemischen Ätzverfahrens gegenüber lokalen Halbleiter-Strukturstörungen mechanisch-physikalischer Natur, beispielsweise aufgrund von Kratzern oder Versetzungsnetzwerken. Die schematische Draufsicht in Figur 11 entspricht dem Bearbeitungszustand nach Figur 7 bei der Herstellung einer Halbleiterlaservorrichtung nach der zweistufigen Strukturierung der Wellenleiterstege 7, ganzflächigem Abscheiden der Oxidüberformung vermittels Sputtern, und Entfernung der Oxidüberformung vermittels Abheben auf den Stegen und den Ritzrahmen 26. Die Bezugsziffer 27 bezeichnet die Kanten der Oxidüberformung bzw. der Passivierungsschicht 9 (vgl. Figuren 6 und 7), die Bezugszeichen 28 bezeichnen Kratzer bzw. mechanische Störungen in der Halbleiterstruktur. Trotz einer deutlich sichtbaren Störung der Ridge-Oberfläche durch mechanische Kratzer ist kein Einfluss auf die lateralen Abmessungen der Laser-Wellenleiter zu erkennen. Bei der zweistufigen Strukturierung des Wellenleitersteges 7 wurde in einer ersten Stufe eine nass-chemische Ätzung vermittels einer Schwefelsäure (75 %-ige Konzentration):Wasserstoffperoxid der Zusammensetzung 60: 1 mit einer Ätzzeit von 40 s, und in einer zweiten Stufe eine nass-chemische Ätzung vermittels einer Phosphorsäure:Salzsäure-Lösung der Zusammensetzung 3: 1 in einer Ätzzeit von 3 min durchgeführt.

Bei Durchführung einer zweistufigen Ätzung zeigt sich insbesondere auch die außergewöhnliche Unempfindlichkeit des erfindungsgemäßen Ätzverfahrens gegenüber Haftungsunterschieden des Maskenmaterials auf der Halbleiteroberfläche. Während bei der ersten selektiven Schichtätzung durch stellenweise massive Unterätzung erhebliche Abweichungen von der linearen Geometrie des Maskenrandes der Abdeckmaske entstehen können, wobei als Ursache hierfür unter anderem eine verminderte Lackhaftung der Abdeckmaske an bestimmten Stellen in Frage kommen kann, wird demgegenüber bei der nachfolgend durchgeführten selektiven Ätzung der zweitobersten Schicht diese aufgrund eines bei der ersten Ätzung entstandenen Spaltes mit etwa 150 nm Breite (entsprechend der Schichtdicke der Oberflächenschicht) überhaupt nicht beeinflusst. Trotz eines vorhandenen makroskopischen Spalts aus dem ersten Ätzschritt findet somit bei Durchführung der erfindungsgemäßen Ätzung keine Unterkriechung und folglich keine Unterätzung des Photolacks statt.

Die Erfindung ermöglicht darüber hinaus eine beliebige Folge von Unterbrechungen und Wiederholungen des Ätzschrittes bis zur Erzielung des gewünschten Ätzergebnisses. Üblicherweise eintretende Veränderungen bzw. Einbußen der Maskenhaftung setzen einer vielfachen Wiederholung oder Nachbesserung einer Ätzung keine Grenzen.

Die Maskenformähnlichkeit geht auch bei erheblicher Unterätzung - chemische Homogenität des Schichtmaterials vorausgesetzt - nicht verloren. Auf schnelle und kostensparende Weise können daher Optimierungen oder nachträgliche Korrekturen von Bauelement-Dimensionierungen auch ohne exakte Anpassung der Maskenmaße vorgenommen werden.

**Patentansprüche**

1. Verfahren zur nass-chemischen Ätzung bzw. Oberflächenreinigung von arsenhaltigen Mischkristallverbindungen bei III-V-Halbleitersystemen, welche insbesondere auf InP und/oder GaAs basieren, wobei zur Durchführung der nass-chemischen Ätzung bzw. Oberflächenreinigung eine Ätz- bzw. Reinigungslösung mit den Bestandteilen Schwefelsäure und einem Oxidationsmittel verwendet wird, wobei die in der Ätz- bzw. Reinigungslösung verwendete Schwefelsäure in einer nichtkonzentrierten, mit Wasser verdünnten Form vorliegt, und die Volumenkonzentration des Oxidationsmittels in der Ätz- bzw. Reinigungslösung kleiner als etwa 3 % ist, **dadurch gekennzeichnet, dass** das Verfahren unter Verwendung einer strukturierten Ätzmaske durchgeführt wird, und der Grad der Richtungsabhängigkeit der Ätzrate durch den Anteil der Volumenkonzentration des Oxidationsmittels eingestellt wird.

2. Verfahren nach Anspruch 1, **dadurch gekennzeichnet, dass** die in der Ätz- bzw. Reinigungslösung verwendete Schwefelsäure in 75 %-iger Konzentration vorliegt.

3. Verfahren nach Anspruch 1 oder 2, **dadurch gekennzeichnet, dass** das in der Ätz- bzw. Reinigungslösung verwendete Oxidationsmittel Wasserstoffperoxid darstellt.

4. Verfahren nach einem der Ansprüche 1 bis 3, **dadurch gekennzeichnet, dass** für den Ansatz der Ätz- bzw. Reinigungslösung eine Schwefelsäure-Wasser-Lösung mit einem voreingestellten Schwefelsäure-Wasser-Verhältnis verwendet wird, und dem Ansatz zur Ätzung einer arsenhaltigen Schicht ein Oxidationsmittel zugegeben wird, dessen Volumenanteil in Abhängigkeit der gewünschten Ätzaktivität der arsenhaltigen Schicht variabel eingestellt wird.

5. Verfahren nach einem der Ansprüche 1 bis 4, **dadurch gekennzeichnet, dass** die nass-chemische Ätzung bzw. Oberflächenreinigung vermittels der strukturierten Ätzmaske insbesondere aus Photolackmaterial durchgeführt wird.

6. Verfahren nach Anspruch 5, **dadurch gekennzeichnet, dass** bei der nass-chemischen Ätzung bzw. Oberflächenreinigung das von der strukturierten Ätzmaske überdeckte Material unterätzt wird.

7. Verfahren nach einem der Ansprüche 1 bis 6 zur Herstellung eines Stegwellenleiters in III-V-Verbindungshalbleiter-Schichtstrukturen mit einer auf einem Halbleiter-Substrat (2) ausgebildeten Grundstruktur mit einer ersten Mantelschicht (3), einer auf der ersten Mantelschicht (3) abgeschiedenen aktiven Zone (4) bestehend aus einheitlichem Material oder aus einer Wechselfolge von Quantentöpfen und Barrieren, einer auf der aktiven Zone (4) abgeschiedenen zweiten Mantelschicht (5) und einer auf der zweiten Mantelschicht (5) abgeschiedenen Kontaktschicht (6), wobei das Ätzen der Kontaktschicht (6) nass-chemisch mit der Ätz- bzw. Reinigungslösung erfolgt.

8. Verfahren nach Anspruch 7 mit den Schritten:

   • Fertigen der Grundstruktur mit der ersten Mantelschicht (3), der aktiven Zone (4), der zweiten Mantelschicht (5) und der Kontaktschicht (6) durch epitaktisches Aufwachsen;
   • ganzflächiges Abscheiden und Strukturieren einer Grabenmaske (12, 13) zur Festlegung eines Grabenbereichs (14), der eine vielfache Breite eines nachfolgend innerhalb des Grabenbereichs (14) aus der zweiten Mantelschicht (5) und der Kontaktschicht (6) zu erzeugenden Steges (7) besitzt;
   • Ausbilden einer im Wesentlichen streifenförmigen Stegmaske (15) innerhalb des Grabenbereichs (14);
   • selektives Ätzen der Kontaktschicht (6) und der zweiten Mantelschicht (5) unter Verwendung der Grabenmaske und der Stegmaske (15) als Abdeckmasken zur Ausbildung des Steges (7) des Stegwellenleiters bei gleichzeitiger Ausbildung eines Grabens (8) innerhalb des Grabenbereiches (14), wobei die Abdeckmasken in vorbestimmter Weise unterätzt werden, und das Ätzen der Kontaktschicht (6) nass-chemisch mit einer Ätz- bzw. Reinigungslösung erfolgt, die eine nichtkonzentrierte, mit Wasser verdünnte Schwefelsäure und ein Oxidationsmittel aufweist, wobei die Volumenkonzentration des Oxidationsmittels in der Ätz- bzw. Reinigungslösung kleiner als etwa 3 % ist;
   • im Wesentlichen kantenkonformes Abscheiden einer Passivierungsschicht (9) aus elektrisch isolierendem Material;
   • Abheben des auf der Stegmaske (15) abgeschiedenen Materials der Passivierungsschicht (9) durch Entfernen des unterliegenden Maskenmaterials der Stegmaske (15); und
   • Abscheiden einer Metallisierungsschicht (11) für den elektrischen Anschluss des Steges (7).

**9.** Verfahren nach Anspruch 8, **dadurch gekennzeichnet, dass** das Ätzen der Kontaktschicht (6) und der zweiten Mantelschicht (5) in zwei voneinander getrennten Ätzschritten mit unterschiedlichen Ätzlösungen durchgeführt wird, wobei die Ätzung der jeweiligen Schicht selektiv gegenüber dem jeweils unterliegenden Material durchgeführt wird.

**10.** Verfahren nach Anspruch 8 oder 9, **dadurch gekennzeichnet, dass** beim nass-chemischen Ätzen der Kontaktschicht (6) das von der Stegmaske (15) abgedeckte Material unterätzt wird.

**11.** Verfahren nach einem der Ansprüche 8 bis 10, **dadurch gekennzeichnet, dass** zur nass-chemischen Ätzung der zweiten Mantelschicht (5) eine Phosphorsäure-Salzsäure-Ätzlösung verwendet wird.

**12.** Verfahren nach einem der Ansprüche 8 bis 11, **dadurch gekennzeichnet, dass** bei der Ätzung der zweiten Mantelschicht (5) keine Unterätzung gegenüber der als Ätzmaske wirkenden, strukturierten Kontaktschicht (6) erfolgt.

**13.** Verfahren nach einem der vorhergehenden Ansprüche 8 bis 12, **dadurch gekennzeichnet, dass** sämtliche nass-chemische Ätzvorgänge in vertikaler Richtung an der zu ätzenden Schicht unmittelbar folgenden Grenzschicht aufgrund der materialspezifischen Selektivität der Ätzlösungen zu stehen kommen.

**14.** Verfahren nach einem der Ansprüche 8 bis 13, **dadurch gekennzeichnet, dass** die Flankenwinkel der Kontaktschicht (6) eindeutig durch die kristallographisch bedingten Eigenschaften des Kontaktschichtmaterials vorgegeben bzw. bestimmt werden.

**15.** Verfahren nach einem der Ansprüche 8 bis 11, **dadurch gekennzeichnet, dass** durch die Stegmaske (15) in einem selbstjustierendem Prozess die Stegposition innerhalb des Grabens festgelegt wird, bezüglich der Breite des Steges aber lediglich der maximale Wert vorbestimmt wird.

**16.** Verfahren nach einem der Ansprüche 8 bis 15, **dadurch gekennzeichnet, dass** die Grabenmaske eine aus Halbleitermaterial bestehende Schicht aufweist und die Stegmaske (15) eine Photolackmaske darstellt.

**17.** Verfahren nach einem der Ansprüche 8 bis 16, **dadurch gekennzeichnet, dass** die Orientierung der Stegmaske (15) und/oder Grabenmaske parallel zu den kristallographischen Richtungen [011] oder

[0$\bar{1}$1] ausgerichtet wird.

**18.** Verfahren nach einem der Ansprüche 8 bis 17, **dadurch gekennzeichnet, dass** die Passivierungsschicht (9) $Al_2O_3$ aufweist und vermittels einem ionenstrahlgestützten Sputter-Prozess-Schritt (16) ganzflächig abgeschieden wird.

**19.** Verfahren nach einem der Ansprüche 8 bis 18, **dadurch gekennzeichnet, dass** auf die Grundstruktur für die Ausbildung der Grabenmaske ganzflächig eine Hilfmaskenschicht (12) abgeschieden wird, die zur Festlegung des Grabenbereiches (14) selektiv geätzt wird.

## Claims

**1.** Process for wet-chemical etching or surface cleaning of arsenic-containing mixed-crystal compounds in III-V semiconductor systems which are based, in particular, on InP and/or GaAs, an etching or cleaning solution having the constituents sulphuric acid and an oxidizing agent being used for carrying out the wet-chemical etching or surface cleaning, the sulphuric acid used in the etching or cleaning solution being present in a non-concentrated form diluted with water, and the volume concentration of the oxidizing agent in the etching or cleaning solution being less than approximately 3%,
**characterized in that**
the process is carried out using a patterned etching mask, and the degree of directional dependence of the etching rate is set by the proportion of the volume concentration of the oxidizing agent.

**2.** Process according to Claim 1, **characterized in that** the sulphuric acid used in the etching or cleaning solution is present in 75% strength concentration.

**3.** Process according to Claim 1 or 2, **characterized in that** the oxidizing agent used in the etching or cleaning solution constitutes hydrogen peroxide.

**4.** Process according to one of Claims 1 to 3, **characterized in that** a sulphuric acid/water solution having a preset sulphuric acid/water ratio is used for the batch of etching or cleaning solution, and an oxidizing agent is added to the batch for etching an arsenic-containing layer, the volume proportion of which oxidizing agent is set in a variable manner depending on the desired etching activity of the arsenic-containing layer.

**5.** Process according to one of Claims 1 to 4, **characterized in that** the wet-chemical etching or surface cleaning is carried out by means of the patterned etching mask made, in particular, of photoresist material.

6. Process according to Claim 5, **characterized, in that** the material covered by the patterned etching mask is undercut during the wet-chemical etching or surface cleaning.

7. Process according to one of Claims 1 to 6 for fabricating a ridge waveguide in III-V compound semiconductor layer structures with a basic structure, formed on a semiconductor substrate (2), having a first cladding layer (3), an active zone (4), deposited on the first cladding layer (3) and composed of a uniform material or of an alternating sequence of quantum wells and barriers, a second cladding layer (5) deposited on the active zone (4), and a contact layer (6) deposited on the second cladding layer (5), the contact layer (6) being etched wet-chemically with the etching or cleaning solution.

8. Process according to Claim 7, having the following steps:

   • production of the basic structure having the first cladding layer (3), the active zone (4), the second cladding layer (5) and the contact layer (6) by epitaxial growth;
   • whole area deposition and patterning of a trench mask (12, 13) for defining a trench region (14), which has a multiple width of a ridge (7) that is subsequently to be produced within the trench region (14) from the second cladding layer (5) and the contact layer (6);
   • formation of an essentially strip-type ridge mask (15) within the trench region (14);
   • selective etching of the contact layer (6) and of the second cladding layer (5) using the trench mask and the ridge mask (15) as covering masks for the purpose of forming the ridge (7) of the ridge waveguide with the simultaneous formation of a trench (8) within the trench region (14), the covering masks being undercut in a predetermined manner, and the contact layer (6) being etched wet-chemically with an etching or cleaning solution which has a non-concentrated sulphuric acid, diluted with water, and an oxidizing agent, the volume concentration of the oxidizing agent in the etching or cleaning solution being less than approximately 3%;
   • essentially edge-conformal deposition of a passivation layer (9) made of electrically insulating material;
   • lift-off of the material of the passivation layer (9) which has been deposited on the ridge mask (15), by removal of the underlying mask material of the ridge mask (15); and

   • deposition of a metallization layer (11) for the electrical connection of the ridge (7).

9. Process according to Claim 8, **characterized in that** the etching of the contact layer (6) and of the second cladding layer (5) is carried out in two mutually separate etching steps using different etching solutions, the etching of the respective layer being carried out selectively relative to the underlying material in each case.

10. Process according to Claim 8 or 9, **characterized in that** the material covered by the ridge mask (15) is undercut during the wet-chemical etching of the contact layer (6).

11. Process according to one of Claims 8 to 10, **characterized in that** a phosphoric acid/hydrochloric acid etching solution is used for the wet-chemical etching of the second cladding layer (5).

12. Process according to one of Claims 8 to 11, **characterized in that** undercutting is not effected relative to the patterned contact layer (6) which acts as an etching mask, during the etching of the second cladding layer (5).

13. Process according to one of the preceding Claims 8 to 12, **characterized in that** all of the wet-chemical etching operations come to a stop in the vertical direction at the boundary layer directly following the layer to be etched, on account of the material-specific selectivity of the etching solutions.

14. Process according to one of Claims 8 to 13, **characterized in that** the sidewall angles of the contact layer (6) are unambiguously defined or determined by the crystallographically governed properties of the contact layer material.

15. Process according to one of Claims 8 to 11, **characterized in that** the ridge position within the trench is defined by the ridge mask (15) in a self-aligning process, but with regard to the width of the ridge only the maximum value is predetermined.

16. Process according to one of Claims 8 to 15, **characterized in, that** the trench mask has a layer composed of semiconductor material and the ridge mask (15) constitutes a photoresist mask.

17. Process according to one of Claims 8 to 16, **characterized in that** the orientation of the ridge mask (15) and/or trench mask is oriented parallel to the crystallographic directions [011] or [011].

18. Process according to one of Claims 8 to 17, **characterized in that** the passivation layer (9) has

Al$_2$O$_3$ and is deposited over the whole area by means of an ion-beam-assisted sputtering process step (16).

19. Process according to one of Claims 8 to 18, **characterized in that** an auxiliary mask layer (12) is deposited over the whole area of the basic structure for forming the trench mask, the said auxiliary mask layer being etched selectively in order to define the trench region (14).

**Revendications**

1. Procédé d'attaque ou de nettoyage chimique par voie humide de surfaces de composés de cristaux mixtes contenant de l'arsenic, dans des systèmes semiconducteurs III/V qui sont réalisés notamment à base de InP et/ou de GaAs, selon lequel pour la mise en oeuvre de l'attaque ou du nettoyage par voie chimique humide de surfaces, on utilise une solution d'attaque ou de nettoyage comportant les constituants formés d'acide sulfurique et d'un agent d'oxydation, et selon lequel l'acide sulfurique utilisé dans la solution d'attaque ou de nettoyage est présent sous une forme non concentrée, diluée avec de l'eau, et la concentration volumique de l'agent d'oxydation dans la solution d'attaque ou de nettoyage est inférieure à environ 3 %, **caractérisé en ce que** le procédé est mis en oeuvre moyennant l'utilisation d'un masque d'attaque structuré, et le degré de la dépendance de la vitesse d'attaque vis-à-vis de la direction est réglé par le pourcentage de la concentration volumique de l'agent d'oxydation.

2. Procédé selon la revendication 1, **caractérisé en ce que** l'acide sulfurique utilisé dans la solution d'attaque ou de nettoyage est présent en une concentration de 75 %.

3. Procédé selon la revendication 1 ou 2, **caractérisé en ce que** l'agent d'oxydation utilisé dans la solution d'attaque ou de nettoyage est du peroxyde d'hydrogène.

4. Procédé selon l'une des revendications 1 à 3, **caractérisé en ce que** pour la formulation de la solution d'attaque ou de nettoyage on utilise une solution acide sulfurique-eau présentant un rapport acide sulfurique-eau préréglé, et à la composition on ajoute, pour réaliser l'attaque d'une couche contenant de l'arsenic, un agent d'oxydation, dont le pourcentage volumique est réglé d'une manière variable en fonction de l'activité d'attaque désiré de la couche contenant de l'arsenic.

5. Procédé selon l'une des revendications 1 à 4, **caractérisé en ce que** l'attaque ou le nettoyage par voie chimique humide de surface est réalisé à l'aide du masque d'attaque structuré, notamment constitué par une photolaque.

6. Procédé selon la revendication 5, **caractérisé en ce que** lors de l'attaque ou du nettoyage de surfaces par voie chimique humide, qu'il se produit une attaque sous-jacente du matériau recouvert par le masque d'attaque structuré.

7. Procédé selon l'une des revendications 1 à 6, pour fabriquer un guide d'ondes à moulure dans des structures de couches semiconductrices de composés III-V possédant une structure de base formée par un substrat semiconducteur (2) et possédant une première couche enveloppe (3), une zone active (4) déposée sur la première couche enveloppe (3) et formée par un matériau uniforme ou par une succession alternée de puits quantiques et de barrières, une seconde couche enveloppe (5) déposée sur la zone active (4) et une couche de contact (6) déposée sur la seconde couche enveloppe (5), l'attaque de la couche de contact (6) s'effectuant par voie chimique humide avec la solution d'attaque ou de nettoyage.

8. Procédé selon la revendication 7, comprenant les étapes suivantes:

   - fabrication de la structure de base avec la première couche enveloppe (3), la zone active (4), la seconde couche enveloppe (5) et la couche de contact (6) par croissance épitaxiale;
   - dépôt et structuration, sur toute la surface, d'un masque de sillon (12, 13) pour déterminer une zone de sillon (14), qui possède une largeur égale à un multiple de la largeur d'une moulure (7) devant être produite ultérieurement à l'intérieur de la zone de sillon (14) à partir de la seconde couche enveloppe (5) et de la couche de contact (6);
   - formation d'un masque de moulure (15) essentiellement en forme de bande, à l'intérieur de la zone de sillon (14);
   - attaque sélective de la couche de contact (6) et de la seconde couche enveloppe (5) moyennant l'utilisation du masque de sillon et du masque de moulure (15) en tant que masque de recouvrement pour la formation de la moulure (7) du guide d'ondes à moulure lors de la formation simultanée d'un sillon (8) à l'intérieur de la zone de sillon (14), les masques de recouvrement étant soumis à une attaque sous-jacente d'une manière prédéterminée, et l'attaque de la couche de contact (6) s'effectuant par voie chimique humide avec une solution d'attaque ou de nettoyage, qui contient de l'acide sulfurique non concentré, dilué à l'eau, et un agent d'oxydation, la concentration volumique de l'agent d'oxydation dans la solution d'attaque ou de nettoyage étant inférieure à environ 3 % ;

- dépôt, essentiellement conforme aux bords, d'une couche de passivation (9) formée d'un matériau électriquement isolant ;
- enlèvement du matériau déposé sur le masque de moulure (15), en tant que couche de passivation (9) par élimination du matériau sous-jacent du masque de moulure (15) ; et
- dépôt d'une couche de métallisation (11) pour le raccordement électrique de la moulure (7).

9. Procédé selon la revendication 8, **caractérisé en ce que** l'attaque de la couche de contact (6) et de la seconde couche enveloppe (5) est réalisée en deux étapes d'attaque séparées l'une de l'autre avec des solutions d'attaque différentes, l'attaque de la couche respective étant exécutée de façon sélective par rapport au matériau respectivement sous-jacent.

10. Procédé selon la revendication 8 ou 9, **caractérisé en ce que** lors de l'attaque chimique par voie humide de la couche de contact (6), le matériau recouvert par le masque de moulure (15) est soumis à une attaque sous-jacente.

11. Procédé selon l'une des revendications 8 à 10, **caractérisé en ce qu'**on utilise une solution d'attaque formée d'acide phosphorique et d'acide chlorhydrique.

12. Procédé selon l'une des revendications 8 à 11, **caractérisé en ce que** lors de l'attaque de la seconde couche enveloppe (5), il ne se produit aucune attaque sous-jacente par rapport à la couche de contact structurée (6) qui agit en tant que masque d'attaque.

13. Procédé selon l'une des revendications précédentes 6 à 12, **caractérisé en ce que** tous les processus d'attaque par voie chimique humide peuvent être s'arrêter dans la direction verticale au niveau de la couche limite qui succède directement à la couche attaquée, en raison de la sélectivité, spécifique au matériau, des solutions d'attaque.

14. Procédé selon l'une des revendications 8 à 13, **caractérisé en ce que** les angles des flancs de la couche de contact (6) sont prédéterminés ou déterminés de façon nette par les caractéristiques, conditionnées par la cristallographie, du matériau de la couche de contact.

15. Procédé selon l'une des revendications 8 à 11, **caractérisé en ce que** lors d'un processus d'autoajustement la position de la moulure à l'intérieur du sillon est fixée par le masque de moulure (15), mais qu'en ce qui concerne la largeur de la moulure, seule la valeur maximale est prédéterminée.

16. Procédé selon l'une des revendications 8 à 15, **caractérisé en ce que** le masque de sillon possède une couche formée d'un matériau semiconducteur et que le masque de moulure (15) représente un masque de photolaque.

17. Procédé selon l'une des revendications 8 à 16, **caractérisé en ce que** l'orientation du masque de moulure (15) et/ou du masque de sillon est parallèle aux directions cristallographiques [011] ou [0$\bar{1}$1].

18. Procédé selon l'une des revendications 8 à 17, **caractérisé en ce que** la couche de passivation (9) comporte du $Al_2O_3$ et est déposée sur toute la surface au moyen d'une étape (16) d'un processus de pulvérisation, assisté à l'aide d'un faisceau d'ions.

19. Procédé selon l'une des revendications 8 à 18, **caractérisé en ce que** pour la formation du masque de sillon on dépose sur la surface de la structure de base, une couche de masque auxiliaire (12), qui est attaquée sélectivement pour la détermination de la zone de sillon (14).

Fig1

Fig2

Fig3

Fig 4

Fig 5

Fig 6

Fig7

Fig8

# Fig 9

# Fig 10

## Fig 11